(19) Europäisches Patentamt European Patent Office Office européen des brevets

(11) **EP 3 618 572 A1**

(12) **EUROPEAN PATENT APPLICATION**
published in accordance with Art. 153(4) EPC

(43) Date of publication:
**04.03.2020 Bulletin 2020/10**

(51) Int Cl.:
**H05B 33/02** (2006.01)      **H01L 51/50** (2006.01)
**H05B 33/10** (2006.01)      **H05B 33/28** (2006.01)

(21) Application number: **18792293.5**

(22) Date of filing: **04.04.2018**

(86) International application number:
**PCT/JP2018/014440**

(87) International publication number:
**WO 2018/198698 (01.11.2018 Gazette 2018/44)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.04.2017 JP 2017086493**
**29.09.2017 JP 2017190706**

(71) Applicant: **Oled Material Solutions Co., Ltd.**
**Higashiomi-shi, Shiga 521-1211 (JP)**

(72) Inventors:
• **YAMAZAKI, Yasuo**
**Higashiomi-shi**
**Shiga 521-1211 (JP)**

• **KAJI, Hironori**
**Uji-shi**
**Kyoto 611-0011 (JP)**
• **KUBO, Shosei**
**Uji-shi**
**Kyoto 611-0011 (JP)**
• **TABE, Masashi**
**Higashiomi-shi**
**Shiga 521-1211 (JP)**
• **SAKAMOTO, Akihiko**
**Higashiomi-shi**
**Shiga 521-1211 (JP)**

(74) Representative: **Tetzner, Michael et al**
**Tetzner & Partner mbB**
**Patent- und Rechtsanwälte**
**Van-Gogh-Strasse 3**
**81479 München (DE)**

(54) **ORGANIC EL DEVICE SUBSTRATE, ORGANIC EL DEVICE, AND METHOD FOR MANUFACTURING ORGANIC EL DEVICE SUBSTRATE**

(57)      Provided is an organic EL device substrate (1) including, in order in a thickness direction: a light-transmitting plate; a high refractive index layer (4); and a transparent conductive layer (5), the organic EL device substrate (1) having a recessed groove portion (6) configured to divide the transparent conductive layer (5) at least into a first region (R1) and a second region (R2). When a thickness of the transparent conductive layer (5) is represented by t1 ($\mu$m), a minimum width of the recessed groove portion (6) is represented by w1 ($\mu$m), and a maximum depth of the recessed groove portion (6) with respect to a surface (5a) of the transparent conductive layer (5) on an opposite side of the high refractive layer (4) is represented by d1 ($\mu$m), the following relationships are established: $t1 \leq d1$; and $d1/\{(w1)^{0.5}\} < 0.1$.

Fig. 2

EP 3 618 572 A1

## Description

Technical Field

The present invention relates to an organic EL device substrate and an organic EL device using the organic EL device substrate, and methods of manufacturing the organic EL device substrate and the organic EL device.

Background Art

In recent years, in various devices for display and illumination, for example, attention has been attracted to the use of an organic electroluminescence (EL) device using an organic EL element in order to reduce thickness and decrease power consumption. However, in the current circumstances, the luminance of the organic EL element is insufficient in many cases, in particular, when the organic EL element is used as a light source for illumination, and hence it is required to further improve light extraction efficiency.

In view of the foregoing, for example, in Patent Literature 1, there is disclosed the use of an organic EL device substrate having a function of scattering light from the organic EL element in order to increase light extraction efficiency. More specifically, the organic EL device substrate disclosed in Patent Literature 1 includes a glass plate, which has a rugged surface for scattering light from the organic EL element formed on a surface on which a transparent conductive film is to be formed. However, in this case, there is a problem in that it is difficult to directly form the transparent conductive film on the rugged surface. Therefore, the organic EL device substrate disclosed in Patent Literature 1 further includes a high refractive index layer made of a baked glass film on the rugged surface of the glass plate, to thereby flatten the surface on which the transparent conductive film is to be formed through use of the high refractive index layer. The high refractive index layer also serves to reduce reflection of light at an interface with respect to the transparent conductive film, to thereby increase light extraction efficiency.

Citation List

Patent Literature

PTL 1: JP 2010-198797 A

Summary of Invention

Technical Problem

The transparent conductive film of the organic EL device substrate is utilized as electrodes (for example, anodes) of the organic EL device. Therefore, a recessed groove portion is formed in the transparent conductive film in accordance with the shape and structure of the device, with the result that the transparent conductive film is divided so as to correspond to a desired electrode shape. An organic EL element layer is formed on a surface of the recessed groove portion in a process of manufacturing the organic EL device so that insulation is kept between electrodes formed of the transparent conductive film to be adjacent to each other through intermediation of the recessed groove portion.

However, even in the organic EL device manufactured as described above, there is a problem in that a large leakage current is generated in the recessed groove portion to impair the light-emitting characteristics of the organic EL device.

The present invention has an object to provide an organic EL device substrate and an organic EL device, with which generation of a leakage current can be reduced.

Solution to Problem

The inventors of the present invention have made extensive investigations, and as a result, have found that a leakage current is caused by the shape of the recessed groove portion. More specifically, in a process of manufacturing an organic EL device through use of an organic EL device substrate, an insulation layer such as an organic EL element layer is formed by vapor deposition or the like. In this case, when a depth of the recessed groove portion is excessively large with respect to a minimum width thereof, it is difficult to form the insulation layer such as the organic EL element layer on the entire surface of the recessed groove portion. Therefore, an exposed portion, in which the insulation layer is not formed, and the transparent conductive layer is exposed, is formed, for example, in a side wall portion of the recessed groove portion, and the exposed portion may cause the generation of a leakage current. In view of the foregoing, the present invention has been conceived by optimizing the dimensional relationship between the minimum width and the maximum depth of the recessed groove portion based on the above-mentioned finding.

An organic EL device substrate according to one embodiment of the present invention devised so as to solve the above-mentioned problem is an organic EL device substrate comprising, in order in a thickness direction: a light-transmitting plate; a high refractive index layer; and a transparent conductive layer, the organic EL device substrate having a recessed groove portion configured to divide the transparent conductive layer at least into a first region and a second region, wherein, when a thickness of the transparent conductive layer is represented by t1 ($\mu$m), a minimum width of the recessed groove portion is represented by w1 ($\mu$m), and a maximum depth of the recessed groove portion with respect to a surface of the transparent conductive layer on an opposite side of the high refractive layer is represented by d1 ($\mu$m), the following relationships are established: $t1 \leq d1$; and $d1/\{(w1)^{0.5}\} < 0.1$. With this configuration, $t1 \leq d1$ is established. Therefore, the maximum depth of the recessed groove portion becomes equal to or more than the thickness of the transparent conductive layer, and the transparent conductive layer can be reliably divided into the first region and the second region by the recessed groove portion. Meanwhile, it has been found also from various experiments that, when $d1/\{(w1)^{0.5}\} < 0.1$ is established, the maximum depth of the recessed groove portion becomes appropriate with respect to the minimum width thereof. Thus, when the organic EL device is manufactured through use of the organic EL device substrate having such dimensional relationship, the insulation layer such as the organic EL element layer can be formed on the entire surface of the recessed groove portion, and hence the generation of a leakage current can be reduced.

In the above-mentioned configuration, it is preferred that the recessed groove portion have a minimum width of 10 $\mu$m or more. With this, the minimum width of the recessed groove portion becomes sufficiently large. Therefore, when the organic EL device is manufactured through use of the organic EL device substrate, the insulation layer such as the organic EL element layer can be easily formed on the entire surface of the recessed groove portion.

In the above-mentioned configuration, an end portion of a side wall portion of the recessed groove portion on the surface side of the transparent conductive layer has a raised portion that is raised from the surface of the transparent conductive layer, and, when a rectangular region having a dimension along a longitudinal direction of the recessed groove portion of 40 $\mu$m and a dimension along a width direction of the recessed groove portion of 10 $\mu$m is formed so as to comprise the end portion of the side wall portion, it is preferred that an area of a portion viewed in plan view in the rectangular region, in which a height of the raised portion with respect to the surface of the transparent conductive layer is 10 nm or more, be 10% or less of an area of the rectangular region. Specifically, when there are a large number of raised portions each having a height of 10 nm or more, the shape of the transparent conductive layer becomes complicated due to the raised portions, which may cause the generation of a leakage current. Therefore, from the viewpoint of preventing the generation of a leakage current more reliably, it is preferred that the area (horizontal projected area) of the raised portions each having a height of 10 nm or more viewed in plan view be set to as small as 10% or less of the area of the rectangular region (40 $\mu$m$\times$10 $\mu$m) as defined in the above-mentioned configuration.

An organic EL device according to one embodiment of the present invention devised so as to solve the above-mentioned problem comprises: the above-mentioned organic EL device substrate; and an organic EL element layer formed on the transparent conductive layer side of the organic EL device substrate. With the above-mentioned configuration, the action and effect similar to those described in the above-mentioned organic EL device substrate can be obtained.

A method of manufacturing an organic EL device substrate according to one embodiment of the present invention devised so as to solve the above-mentioned problem is a method of manufacturing an organic EL device substrate, the organic EL device substrate comprising, in order in a thickness direction, a light-transmitting plate, a high refractive index layer, and a transparent conductive layer, the method comprising a laser processing step of removing a part of the transparent conductive layer by laser processing to form a recessed groove portion configured to divide the transparent conductive layer at least into a first region and a second region, wherein the laser processing step comprises forming the recessed groove portion so that, when a thickness of the transparent conductive layer is represented by t1 ($\mu$m), a minimum width of the recessed groove portion is represented by w1 ($\mu$m), and a maximum depth of the recessed groove portion with respect to a surface of the transparent conductive layer on an opposite side of the high refractive layer is represented by d1 ($\mu$m), the following relationships are established: $t1 \leq d1$; and $d1/\{(w1)^{0.5}\} < 0.1$. With the above-mentioned configuration, the action and effect similar to those in the corresponding configuration described in the above-mentioned organic EL device substrate can be obtained. In addition, the recessed groove portion is formed by laser processing instead of wet etching. Therefore, even when a material poor in water resistance and chemical resistance is selected for the high refractive index layer, damage to the high refractive index layer can be reduced. Specifically, for example, as a material for the high refractive index layer, a bismuth-based glass composition, a lead-based glass composition, a lanthanum-based glass composition, or the like can be selected without any problem.

In the above-mentioned configuration, it is preferred that the laser processing step comprise forming the recessed groove portion so that the recessed groove portion has a minimum width of 10 $\mu$m or more.

In the above-mentioned configuration, the method of manufacturing the organic EL device substrate further comprises a polishing step of polishing the surface of the transparent conductive layer after the laser processing step,

wherein, after the polishing step, an end portion of a side wall portion of the recessed groove portion on the surface side of the transparent conductive layer has a raised portion that is raised from the surface of the transparent conductive layer, and wherein it is preferred that the surface of the transparent conductive layer be polished so that, when a rectangular region having a dimension along a longitudinal direction of the recessed groove portion of 40 μm and a dimension along a width direction of the recessed groove portion of 10 μm is formed so as to comprise the end portion of the side wall portion, an area of a portion viewed in plan view in the rectangular region, in which a height of the raised portion with respect to the surface of the transparent conductive layer is 10 nm or more, is 10% or less of an area of the rectangular region.

A method of manufacturing an organic EL device according to the present invention devised so as to solve the above-mentioned problem comprises: a step of obtaining an organic EL device substrate by the above-mentioned method of manufacturing an organic EL device substrate; and a step of forming an organic EL element layer on a transparent conductive layer side of the organic EL device substrate. With the above-mentioned configuration, the action and effect similar to those described in the above-mentioned organic EL device substrate and the above-mentioned method of manufacturing an organic EL device substrate can be obtained.

Advantageous Effects of Invention

As described above, according to the present invention, it is possible to provide the organic EL device substrate and the organic EL device, with which the generation of the leakage current can be reduced.

Brief Description of Drawings

FIG. 1 is a cross-sectional view of an organic EL device substrate.
FIG. 2 is an enlarged cross-sectional view of a periphery of a recessed groove portion of the organic EL device substrate.
FIG. 3 is an atomic force micrograph of the periphery of the recessed groove portion of the organic EL device substrate.
FIG. 4 is a cross-sectional view of an organic EL device.
FIG. 5A is a scanning electron microphotograph of a periphery of a recessed groove portion of an organic EL device substrate of an Example.
FIG. 5B is a scanning electron microphotograph of an inside of the recessed groove portion of the organic EL device substrate of the Example.
FIG. 6 is a cross-sectional view for illustrating a modification example of an organic EL device substrate.

Description of Embodiment

Now, an embodiment of the present invention is described with reference to the accompanying drawings.

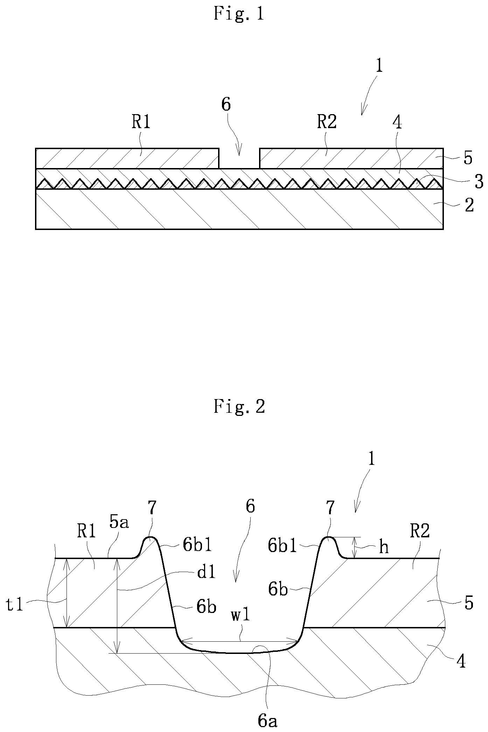

As illustrated in FIG. 1, an organic EL device substrate 1 comprises a light-transmitting plate 2, an irregular layer 3, a high refractive index layer 4, and a transparent conductive layer 5 in the stated order in a thickness direction. Each of the light-transmitting plate 2, the irregular layer 3, the high refractive index layer 4, and the transparent conductive layer 5 has light transparency.

The light-transmitting plate 2 is formed of a glass, a resin, or the like. Examples of the glass for forming the light-transmitting plate 2 include soda lime glass, borosilicate glass, alkali-free glass, and quartz glass. Examples of the resin for forming the light-transmitting plate 2 include an acrylic resin, a silicone resin, an epoxy resin, a polyester resin, and a polycarbonate resin.

The irregular layer 3 is formed of a sintered glass layer having an irregular shape. It is preferred that a refractive index nd of the irregular layer 3 be substantially the same as a refractive index nd of the light-transmitting plate 2. In this case, it is preferred that the refractive index nd of the irregular layer 3 fall within a range of ±0.1 with respect to the refractive index nd of the light-transmitting plate 2. Here, the refractive index nd represents a refractive index at a wavelength of 588 nm. The surface of the light-transmitting plate 2 may be formed of an irregular surface instead of the irregular layer 3. As a method of forming the irregular surface, there are given mechanical treatment methods, such as a sandblasting method, a press forming method, and a roll forming method, and chemical treatment methods, such as a sol-gel spray method, an etching method, and an atmospheric-pressure plasma treatment method. In addition, a substance having a refractive index different from that of a base material for the high refractive index layer 4 may be dispersed in the base material for the high refractive index layer 4 instead of the irregular shape such as the irregular layer 3 or the irregular surface or in combination therewith. It is preferred that the dispersed substance be a substance having a refractive index smaller than the refractive index of the base material for the high refractive index layer 4.

Examples of the dispersion substance include: gases (air bubbles), such as air, oxygen, nitrogen, and carbon dioxide; ceramics particles, such as titania, zirconia, and silica; and inorganic particles, such as glass (amorphous glass or crystallized glass) particles.

The high refractive index layer 4 has a refractive index larger than the refractive index of the light-transmitting plate 2. The refractive index nd of the high refractive index layer is not particularly limited, and is, for example, from 1.8 to 2.1. The high refractive index layer 4 is made of glass (amorphous glass or crystallized glass), a resin, ceramics, or the like. It is preferred that the high refractive index layer 4 be formed of a sintered glass layer. Examples of the glass for forming the sintered glass layer include inorganic glasses, such as soda lime glass, borosilicate glass, aluminosilicate glass, phosphate glass, bismuth-based glass, lead-based glass, and lanthanum-based glass. Of those, bismuth-based glass is particularly preferred because bismuth-based glass is lead-free glass having a high refractive index and can be sintered at a low temperature. However, bismuth-based glass has a high specific dielectric constant, and hence the charge density in a surface layer portion of the high refractive index layer 4 is liable to be increased, with the result that a leakage current from a recessed groove portion 6 described later is liable to be increased. Thus, in the organic EL element substrate comprising the high refractive index layer 4 containing bismuth-based glass, the usefulness of the present invention capable of reducing the generation of a leakage current is particularly outstanding. The specific dielectric constant of the high refractive index layer 4 is preferably from 9 to 23, more preferably from 10 to 22.

Examples of the transparent conductive layer 5 include indium tin oxide (ITO), aluminum zinc oxide (AZO), and indium zinc oxide (IZO).

As glass powder to be used for forming the irregular layer 3, for example, glass powder containing, in terms of mass%, 30% of $SiO_2$, 40% of $B_2O_3$, 10% of ZnO, 5% of $Al_2O_3$, and 15% of $K_2O$ can be used. In addition, the irregular shape of the irregular layer 3 also depends on the particle diameter of the glass powder in addition to the heat treatment condition for sintering a frit paste. The powder grain size ($D_{50}$) of the glass powder is within a range of preferably from 0.3 $\mu$m to 15 $\mu$m, more preferably from 1.0 $\mu$m to 10 $\mu$m, still more preferably from 1.5 $\mu$m to 8 $\mu$m.

As the glass powder to be used for forming the high refractive index layer 4, for example, bismuth-based glass powder containing, in terms of mass%, 70% of $Bi_2O_3$, 5% of $SiO_2$, 10% of ZnO, 10% of $B_2O_3$, and 5% of $Al_2O_3$ and having a specific dielectric constant of 17 can be used. When light-transmitting electrodes or the like are to be formed on the surface of the high refractive index layer 4, it is preferred that the surface of the high refractive index layer 4 be smooth. In order to obtain the smooth surface, it is preferred that the grain size of the glass powder be appropriately set in addition to the heat treatment condition for sintering the frit paste. The powder grain size ($D_{50}$) of the glass powder is preferably from 0.1 $\mu$m to 20 $\mu$m, more preferably from 0.2 $\mu$m to 15 $\mu$m, still more preferably from 0.3 $\mu$m to 10 $\mu$m.

The recessed groove portion 6 configured to divide the transparent conductive layer 5 at least into a first region R1 and a second region R2 is formed in the transparent conductive layer 5. The recessed groove portion 6 has the following feature. Specifically, as illustrated in FIG. 2, when the thickness of the transparent conductive layer 5 is represented by t1, the minimum width of the recessed groove portion 6 is represented by w1, and the maximum depth of the recessed groove portion 6 with reference to a surface 5a of the transparent conductive layer 5 on an opposite side of the high refractive index layer 4 is represented by d1, the following relationships are established.

$$t1 \leq d1 \quad \cdots\cdots \quad (1)$$

$$d1/\{(w1)^{0.5}\} < 0.1 \quad \cdots\cdots \quad (2)$$

In the expression (2), values converted in terms of $\mu$m are used for d1 and w1.

According to the expression (1), the first region R1 and the second region R2 are completely separated from each other, and hence the first region R1 and the second region R2 are not brought into direct conduction with each other through the transparent conductive layer 5. In the expression (1), it is preferred that t1<d1 be established. In this case, as illustrated in FIG. 2, the high refractive index layer 4 is exposed in a bottom wall portion 6a of the recessed groove portion 6.

In addition, according to the expression (2), the maximum depth d1 of the recessed groove portion 6 becomes appropriate with respect to the minimum width w1 thereof. Thus, when an organic EL device is manufactured through use of the organic EL device substrate 1 having such dimensional relationship, an insulation layer such as an organic EL element layer can be formed on the entire surface of the recessed groove portion 6. Therefore, the generation of a leakage current can be reduced to a problem-free level. In the expression (2), $d1/\{(w1)^{0.5}\}$ is preferably 0.08 or less, more preferably 0.06 or less, still more preferably 0.04 or less.

The maximum depth d1 of the recessed groove portion 6 is preferably 1 $\mu$m or less, more preferably 0.8 $\mu$m or less, still more preferably 0.5 $\mu$m or less.

The minimum width w1 of the recessed groove portion 6 is preferably 10 μm or more, more preferably 15 μm or more, still more preferably 20 μm or more. Here, it is preferred that the minimum width w1 of the recessed groove portion 6 be a width at a position corresponding to the bottom wall portion 6a. In addition, it is preferred that a pair of side wall portions 6b of the recessed groove portion 6, which are opposed to each other in a groove width direction, be inclined outward so that the groove width of the recessed groove portion 6 is enlarged from the bottom wall portion 6a to the surface 5a side of the transparent conductive layer 5.

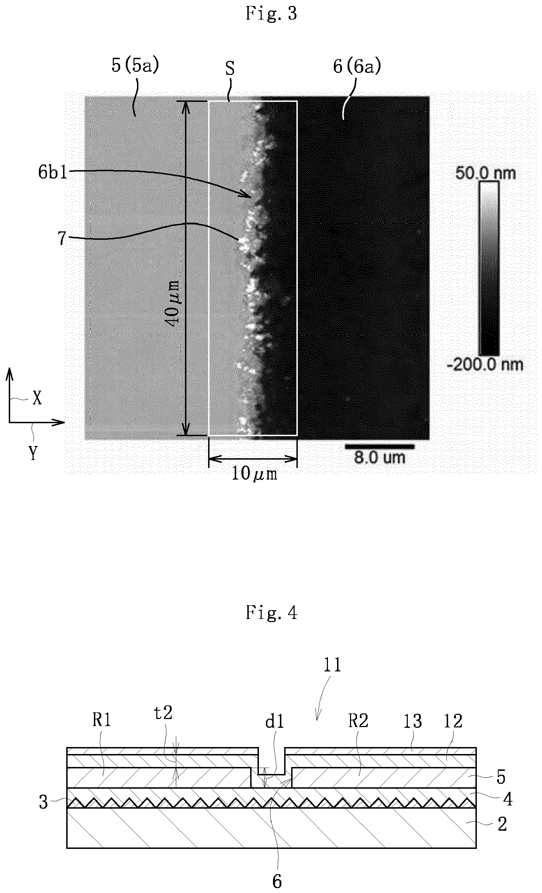

End portions 6b1 of the side wall portions 6b of the recessed groove portion 6 on the surface 5a side of the transparent conductive layer 5 have raised portions 7 that are raised from the surface 5a of the transparent conductive layer 5, respectively. It is preferred that the raised portions 7 have the following feature. Specifically, as shown in FIG. 3, when a rectangular region S having a dimension along a longitudinal direction X of the recessed groove portion 6 of 40 μm and a dimension along a width direction Y of the recessed groove portion 6 of 10 μm is formed so as to comprise the end portion 6b1 of the side wall portion 6b, an area (hereinafter sometimes simply referred to as "raised portion area") of portions viewed in plan view in the rectangular region S, in which a height h (see FIG. 2) of each of the raised portions 7 with respect to the surface 5a of the transparent conductive layer 5 is 10 nm or more, is preferably 10% or less, more preferably 5% or less, still more preferably 2% or less of an area of the rectangular region S. There is no particular limitation on the position of the rectangular region S in a planar direction (X-direction and Y-direction) as long as the condition that the region comprises the end portion 6b1 of the side wall portion 6b is satisfied.

The organic EL device substrate 1 may satisfy the following relational expression.

$$d1/t1 < 4 \quad \cdots\cdots \quad (3)$$

As illustrated in FIG. 4, an organic EL device 11 further comprises an organic EL element layer 12 and cathodes 13 on the organic EL device substrate 1 of FIG. 1. The organic EL element layer 12 and the cathodes 13 are formed on the transparent conductive layer 5 side. The transparent conductive layer 5 serves as anodes. The cathodes 13 are each formed of a metal layer of aluminum or the like, and have light reflectivity in this embodiment. The organic EL element layer 12 comprises a light-emitting layer, and a hole injection layer, a hole transport layer, and the like are formed between the light-emitting layer and the transparent conductive layer 5 as required. In addition, an electron transport layer, an electron injection layer, and the like are formed between the light-emitting layer and the cathodes 13 as required.

It is preferred that, when the thickness of the organic EL element layer 12 in a non-formation region of the recessed groove portion 6 of the transparent conductive layer 5 is represented by t2, the following relationship is established between the thickness t2 and the maximum depth d1 of the recessed groove portion 6.

$$d1/t2 \leq 3 \quad \cdots\cdots \quad (4)$$

The maximum depth d1 of the recessed groove portion 6 is more preferably 2.5 times or less, still more preferably 2 times or less the thickness t2 of the organic EL element layer 12.

Light emitted from the organic EL element layer 12 passes through the transparent conductive layer 5 and the light-transmitting plate 2 to be extracted outside from the light-transmitting plate 2 side. In this case, light reflected from the cathodes 13 is also extracted outside from the light-transmitting plate 2 side.

In the organic EL device 11 configured as described above, the light extraction efficiency is high, and a leakage current that may adversely affect the light-emitting characteristics is extremely small. Therefore, the organic EL device 11 can be suitably used for, for example, illumination.

Next, a method of manufacturing the organic EL device configured as described above is described. A method of manufacturing an organic EL device substrate is also described in the method of manufacturing an organic EL device.

The method of manufacturing an organic EL device comprises: an irregular layer forming step of forming the irregular layer 3 on the light-transmitting plate 2; a high refractive index layer forming step of forming the high refractive index layer 4 on the irregular layer 3; a transparent conductive layer forming step of forming the transparent conductive layer 5 on the high refractive index layer 4; an organic EL element layer forming step of forming the organic EL element layer 12 on the transparent conductive layer 5; and a cathode forming step of forming the cathodes 13 on the organic EL element layer 12. Of those, the steps of from the irregular layer forming step to the transparent conductive layer forming step are those related to the method of manufacturing an organic EL device substrate. The manufacturing process of the organic EL device substrate is performed, for example, by a glass manufacturer, and the remaining steps comprised in the manufacturing process of the organic EL device are performed, for example, by an organic EL device manufacturer.

In the irregular layer forming step, after a frit paste containing glass powder is applied or printed on the surface of the light-transmitting plate 2, the frit paste is sintered (first heat treatment). With this, the irregular layer 3 formed of a sintered glass layer is formed on the light-transmitting plate 2. In this case, the heat treatment temperature in the first heat treatment is required to be set to be lower than the heat-resistant temperature of the light-transmitting plate 2, and is preferably lower than the softening point (for example, 730°C) of the light-transmitting plate 2, more preferably lower by from about 50°C to about 200°C than the softening point of the light-transmitting plate 2.

In the high refractive index layer forming step, after a frit paste containing glass powder is applied or printed on the irregular layer 3 (or the irregular layer 3 and the light-transmitting plate 2), the frit paste is sintered (second heat treatment). With this, the high refractive index layer 4 formed of a sintered glass layer is formed on the irregular layer 3. In this case, it is preferred that the heat treatment temperature in the second heat treatment be lower than the heat treatment temperature in the first heat treatment. With this, the irregular layer 3 formed by the first heat treatment maintains the form thereof also in the second heat treatment.

In the transparent conductive layer forming step, first, the transparent conductive layer 5 is formed on the high refractive index layer 4 by a known procedure such as sputtering, vapor deposition, or CVD. After that, a part of the transparent conductive layer 5 is removed by laser processing in accordance with a predetermined patterning shape (laser processing step). With this, the recessed groove portion 6 is formed in the transparent conductive layer 5, to thereby divide the transparent conductive layer 5 at least into the first region R1 and the second region R2. For example, a pulse laser is used for laser processing.

In the laser processing step, the recessed groove portion 6 is formed so that the relationships of the above-mentioned expressions (1) and (2) are established. In this case, the minimum width w1 and/or the maximum depth d1 of the recessed groove portion 6 are/is adjusted, for example, through adjustment of a laser power and an irradiation spot diameter.

After the laser processing step, the raised portions 7 that are raised from the surface 5a of the transparent conductive layer 5 may be formed in the end portions 6b1 of the side wall portions 6b of the recessed groove portion 6 on the surface 5a side of the transparent conductive layer 5 due to the influence of heat during the laser processing. Therefore, in the transparent conductive layer forming step in this embodiment, the surface 5a of the transparent conductive layer 5 is polished after the laser processing step. The polishing step is performed, for example, by buffing. With this, the raised portion area is set to be 10% or less of the area of the rectangular region S. The raised portions 7 are not limited to those formed by the laser processing.

In the organic EL element layer forming step, the organic EL element layer 12 is formed on the transparent conductive layer 5 by vapor deposition. The organic EL element layer 12 is formed also in the recessed groove portion 6, to thereby serve to keep insulation between the first region R1 and the second region R2. In this case, it is preferred that the organic EL element layer 12 be formed so that the relationship of the above-mentioned expression (3) is established.

In the cathode forming step, the cathodes 13 are formed on the organic EL element layer 12 by a known procedure such as sputtering, vapor deposition, or CVD.


Examples

First, the manufacturing conditions of each of organic EL devices according to Examples of the present invention are described.

As a light-transmitting plate, a soda lime glass substrate having a thickness of 0.7 mm was prepared. A frit paste for forming an irregular layer was applied on the surface of the glass substrate so as to have a thickness of about 25 μm through use of a screen printing machine. After the frit paste for forming an irregular layer was dried at 130°C, first heat treatment was performed at 600°C through use of an electric furnace. Through the first heat treatment, glass particles of glass powder in the frit paste for forming an irregular layer were fused to each other to form an irregular layer on the surface of the glass substrate.

A frit paste for forming a high refractive index layer was applied on each of the glass substrate and the irregular layer so as to have a thickness of about 80 μm through use of a die coater. After the frit paste for forming a high refractive index layer was dried at 130°C, second heat treatment was performed at 580°C through use of the electric furnace. The heat treatment temperature in the second heat treatment is lower than the heat treatment temperature in the first heat treatment, and hence the irregular layer formed by the first heat treatment maintains the form thereof also in the second heat treatment. Through the second heat treatment, glass particles of glass powder in the frit paste for forming a high refractive index layer are fused to each other and flow in a planar direction, with the result that a high refractive index layer having a flat and smooth surface is formed.

A transparent conductive layer formed of an ITO film having a thickness of 120 nm was formed on the high refractive index layer by a sputtering device. After that, the transparent conductive layer was subjected to laser processing by a pulse laser device (R-100 manufactured by Raydiance Inc.) having a wavelength of 1,550 nm, to thereby form a recessed groove portion in the transparent conductive layer. In this case, the depth and width of the recessed groove portion were controlled through adjustment of a laser power and an irradiation spot diameter.

After the above-mentioned laser processing, the surface of the transparent conductive film was polished by buffing to manufacture an organic EL device substrate.

Further, an organic layer having a thickness of 150 nm comprising a hole injection layer, a light-emitting layer, an electron transport layer, and an electron injection layer, and aluminum electrodes (cathodes) each having a thickness of 80 nm were formed on the above-mentioned organic EL device substrate by vacuum vapor deposition, to thereby manufacture an organic EL device.

Meanwhile, each of organic EL devices according to Comparative Examples was manufactured by changing the depth and width of the recessed groove portion under a laser irradiation condition different from that in Examples in the manufacturing process of each of the organic EL devices according to Examples described above. The manufacturing conditions other than the laser irradiation condition are the same as those in Examples.

A leakage current was evaluated in each of Examples 1 to 9 and Comparative Examples 1 to 4. A leakage current was evaluated by manufacturing organic EL devices each having a light-emitting area of 2 mm×2 mm and measuring current-voltage characteristics of each of the manufactured organic EL devices by a 2400-series source meter manufactured by Keithley Instruments in each of Examples 1 to 9 and Comparative Examples 1 to 4. In this case, a current value at a time when a voltage was 2 V was defined as a leakage current ($mA/cm^2$). The results are shown in Table 1.

[Table 1]

| | Example 1 | Example 2 | Example 3 | Example 4 | Example 5 | Example 6 | Example 7 | Example 8 | Example 9 | Comparative Example 1 | Comparative Example 2 | Comparative Example 3 | Comparative Example 4 |
|---|---|---|---|---|---|---|---|---|---|---|---|---|---|
| Thickness $t1$ (nm) of transparent conductive layer | 120 | 120 | 120 | 120 | 120 | 120 | 120 | 120 | 120 | 120 | 120 | 120 | 120 |
| Thickness $t2$ (nm) of organic EL element layer | 150 | 150 | 150 | 150 | 150 | 150 | 150 | 150 | 150 | 150 | 150 | 150 | 150 |
| Maximum depth $d1$ (nm) of recessed groove portion | 200 | 200 | 200 | 800 | 800 | 200 | 450 | 200 | 200 | 550 | 800 | 250 | 550 |
| Minimum width $w1$ ($\mu$m) of recessed groove portion | 200 | 25 | 10 | 200 | 100 | 25 | 25 | 200 | 200 | 25 | 50 | 5 | 25 |
| $d1/[(w1)^{0.5}]$ *$d1$ and $w1$ are obtained by conversion in terms of $\mu$m | 0.01 | 0.04 | 0.06 | 0.06 | 0.08 | 0.04 | 0.09 | 0.01 | 0.01 | 0.11 | 0.11 | 0.11 | 0.11 |
| Raised portion area (%) | 0.50 | 0.50 | 0.50 | 0.50 | 0.50 | 2.60 | 0.50 | 5.00 | 10.00 | 0.50 | 0.50 | 0.50 | 15.00 |
| Leakage current (mA/cm$^2$) | $3\times10^{-6}$ | $5\times10^{-6}$ | $1\times10^{-5}$ | $1\times10^{-5}$ | $5\times10^{-5}$ | $3\times10^{-5}$ | $7\times10^{-5}$ | $1\times10^{-5}$ | $7\times10^{-5}$ | $1\times10^{-4}$ | $5\times10^{-4}$ | $1\times10^{-3}$ | $3\times10^{-3}$ |

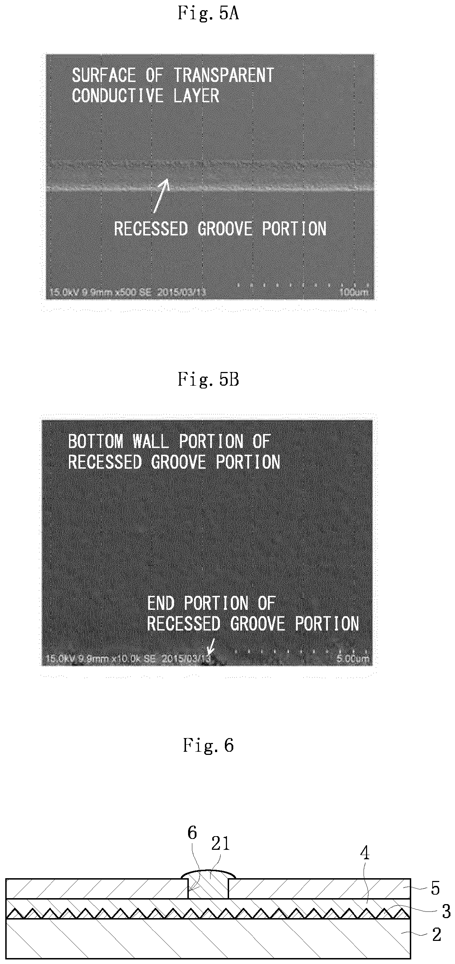

It can be confirmed in Table 1 that, in each of Examples 1 to 9 in which $d1/\{(w1)^{0.5}\}$ became less than 0.1, a leakage current is $7 \times 10^{-5}$ mA/cm$^2$ or less, and hence a value suitable as the organic EL device is obtained. Here, the state of the recessed groove portion in the organic EL device substrate used in the organic EL device of Example 2 was observed with a scanning electron microscope. As a result, as shown in FIG. 5A and FIG. 5B, the transparent conductive film was uniformly removed, and the high refractive index layer was exposed in the bottom wall portion of the recessed groove portion. In addition, damages such as cracks, fusion, and discoloration were not found in the exposed high refractive index layer.

In contrast, in each of Comparative Examples 1 to 4 in which $d1/\{(w1)^{0.5}\}$ became 0.1 or more, a leakage current was $1 \times 10^{-4}$ mA/cm$^2$ or more, and hence a leakage current became much larger than as in the case of Examples 1 to 9.

Here, in each of Examples 1 to 9 and Comparative Examples 1 to 3, the ratio of the raised portion area with respect to the area of the rectangular region was 10% or less. Therefore, even in Comparative Examples 1 to 3, a leakage current was smaller than that in Comparative Example 4 in which the ratio of the raised portion area with respect to the area of the rectangular region was more than 10%.

The present invention is not limited to the configurations of the above-mentioned embodiment and Examples. In addition, the action and effect of the present invention are not limited to those described above. The present invention may be modified in various forms within the range not departing from the spirit of the present invention.

In the above-mentioned embodiment, there is illustrated the case in which the organic EL element layer 12 is formed in the recessed groove portion 6, and the recessed groove portion 6 is insulated. However, as illustrated in FIG. 6, an insulating resin 21 may be filled into the recessed groove portion 6 instead of the organic EL element layer 12. Filling of the insulating resin 21 may be performed in the manufacturing process of the organic EL device substrate 1 or in the manufacturing process of the organic EL device 11. In the former case, the organic EL device substrate 1 comprises the insulating resin 21 in the recessed groove portion 6.

Reference Signs List

| | |
|---|---|
| 1 | organic EL device substrate |
| 2 | light-transmitting plate |
| 3 | irregular layer |
| 4 | high refractive index layer |
| 5 | transparent conductive layer |
| 5a | surface |
| 6 | recessed groove portion |
| 6a | bottom wall portion |
| 6b | side wall portion |
| 7 | raised portion |
| 11 | organic EL device |
| 12 | organic EL element layer |
| 13 | cathode |
| 21 | insulating resin |
| R1 | first region |
| R2 | second region |
| S | rectangular region |
| d1 | maximum depth of recessed groove portion |
| w1 | minimum width of recessed groove portion |

**Claims**

1. An organic EL device substrate, comprising, in order in a thickness direction:

   a light-transmitting plate;
   a high refractive index layer; and
   a transparent conductive layer,
   the organic EL device substrate having a recessed groove portion configured to divide the transparent conductive layer at least into a first region and a second region,
   wherein, when a thickness of the transparent conductive layer is represented by t1 ($\mu$m), a minimum width of the recessed groove portion is represented by w1 ($\mu$m), and a maximum depth of the recessed groove portion with respect to a surface of the transparent conductive layer on an opposite side of the high refractive layer is represented by d1 ($\mu$m), the following relationships are established:

$$t1 \leq d1;$$

and

$$d1 / \{ (w1)^{0.5} \} < 0.1.$$

2. The organic EL element substrate according to claim 1, wherein the recessed groove portion has a minimum width of 10 $\mu$m or more.

3. The organic EL device substrate according to claim 1 or 2,
   wherein an end portion of a side wall portion of the recessed groove portion on the surface side of the transparent conductive layer has a raised portion that is raised from the surface of the transparent conductive layer, and
   wherein, when a rectangular region having a dimension along a longitudinal direction of the recessed groove portion of 40 $\mu$m and a dimension along a width direction of the recessed groove portion of 10 $\mu$m is formed so as to comprise the end portion of the side wall portion, an area of a portion viewed in plan view in the rectangular region, in which a height of the raised portion with respect to the surface of the transparent conductive layer is 10 nm or more, is 10% or less of an area of the rectangular region.

4. An organic EL device, comprising:

   the organic EL device substrate of any one of claims 1 to 3; and
   an organic EL element layer formed on the transparent conductive layer side of the organic EL device substrate.

5. A method of manufacturing an organic EL device substrate,
   the organic EL device substrate comprising, in order in a thickness direction:

   a light-transmitting plate;
   a high refractive index layer; and
   a transparent conductive layer,

   the method comprising a laser processing step of removing a part of the transparent conductive layer by laser processing to form a recessed groove portion configured to divide the transparent conductive layer at least into a first region and a second region,
   wherein the laser processing step comprises forming the recessed groove portion so that, when a thickness of the transparent conductive layer is represented by t1 ($\mu$m), a minimum width of the recessed groove portion is represented by w1 ($\mu$m), and a maximum depth of the recessed groove portion with respect to a surface of the transparent conductive layer on an opposite side of the high refractive layer is represented by d1 ($\mu$m), the following relationships are established:

$$t1 \leq d1;$$

and

$$d1 / \{ (w1)^{0.5} \} < 0.1.$$

6. The method of manufacturing an organic EL device substrate according to claim 5, wherein the laser processing step comprises forming the recessed groove portion so that the recessed groove portion has a minimum width of 10 $\mu$m or more.

7. The method of manufacturing an organic EL device substrate according to claim 5 or 6, further comprising a polishing step of polishing the surface of the transparent conductive layer after the laser processing step,

wherein, after the polishing step, an end portion of a side wall portion of the recessed groove portion on the surface side of the transparent conductive layer has a raised portion that is raised from the surface of the transparent conductive layer, and

wherein the surface of the transparent conductive layer is polished so that, when a rectangular region having a dimension along a longitudinal direction of the recessed groove portion of 40 $\mu$m and a dimension along a width direction of the recessed groove portion of 10 $\mu$m is formed so as to comprise the end portion of the side wall portion, an area of a portion viewed in plan view in the rectangular region, in which a height of the raised portion with respect to the surface of the transparent conductive layer is 10 nm or more, is 10% or less of an area of the rectangular region.

Fig. 1

Fig. 2

Fig. 3

Fig. 4

Fig. 5A

SURFACE OF TRANSPARENT
CONDUCTIVE LAYER

RECESSED GROOVE PORTION

15.0kV 9.9mm x500 SE 2015/03/13    100um

Fig. 5B

BOTTOM WALL PORTION OF
RECESSED GROOVE PORTION

END PORTION OF
RECESSED GROOVE PORTION

15.0kV 9.9mm x10.0k SE 2015/03/13    5.00um

Fig. 6

| | **INTERNATIONAL SEARCH REPORT** | International application No. |
|---|---|---|
| | | PCT/JP2018/014440 |

A. CLASSIFICATION OF SUBJECT MATTER
Int.Cl. H05B33/02(2006.01)i, H01L51/50(2006.01)i, H05B33/10(2006.01)i, H05B33/28(2006.01)i

According to International Patent Classification (IPC) or to both national classification and IPC

B. FIELDS SEARCHED

Minimum documentation searched (classification system followed by classification symbols)
Int.Cl. H05B33/02, H01L51/50, H05B33/10, H05B33/28

Documentation searched other than minimum documentation to the extent that such documents are included in the fields searched
Published examined utility model applications of Japan 1922–1996
Published unexamined utility model applications of Japan 1971–2018
Registered utility model specifications of Japan 1996–2018
Published registered utility model applications of Japan 1994–2018

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2012/053625 A1 (SONY CORPORATION) 26 April 2012, specification, page 13, line 15 to page 14, line 17, page 19, line 12 to page 23, line 1, page 29, line 23 to page 30, line 3, page 34, lines 14–24, page 46, line 24 to page 47, line 13, table 1, fig. 11, 14<br>& US 2013/0220680 A1, paragraphs [0081], [0082], [0104]–[0112], [0133], [0148], [0211]–[0215], table 1, fig. 11A–11D, 14 & EP 2632236 A1 & CN 103155725 A & RU 2013116970 A | 1–6<br>7 |

☒ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 13.06.2018 | 26.06.2018 |

| Name and mailing address of the ISA/<br>Japan Patent Office<br>3-4-3, Kasumigaseki, Chiyoda-ku,<br>Tokyo 100-8915, Japan | Authorized officer |
|---|---|
| | Telephone No. |

Form PCT/ISA/210 (second sheet) (January 2015)

**INTERNATIONAL SEARCH REPORT**

| International application No. |
| --- |
| PCT/JP2018/014440 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 2010-286615 A (SONY CORPORATION) 24 December 2010, paragraphs [0060], [0085], fig. 17, 27 (Family: none) | 7 |
| A | JP 2012-204170 A (SONY CORPORATION) 22 October 2012, paragraphs [0135], [0136], fig. 20 & US 8872039 B2, columns 26, 27, fig. 20 & CN 102695363 A | 1-7 |
| A | WO 2016/100303 A2 (CARBONICS INC.) 23 June 2016, whole documents, all figures & US 2016/0172596 A1 | 1-7 |

Form PCT/ISA/210 (continuation of second sheet) (January 2015)

**EP 3 618 572 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010198797 A